(19) Europäisches Patentamt
European Patent Office
Office européen des brevets

(11) EP 0 721 514 B1

(12) **EUROPEAN PATENT SPECIFICATION**

(45) Date of publication and mention of the grant of the patent:
**22.09.1999 Bulletin 1999/38**

(21) Application number: **95919878.9**

(22) Date of filing: **15.05.1995**

(51) Int Cl.6: **C23C 16/00**, C23F 1/02, C23C 14/00, H01J 37/32

(86) International application number:
**PCT/US95/06242**

(87) International publication number:
**WO 95/32315 (30.11.1995 Gazette 1995/51)**

# (54) MAGNETICALLY ENHANCED MULTIPLE CAPACITIVE PLASMA GENERATION APPARATUS AND RELATED METHOD

MAGNETISCH VERBESSERTE MULTIPLE KAPAZITIVE PLASMAGENERATIONSVORRICHTUNG UND VERFAHREN

GENERATEUR DE PLASMA A CAPACITES MULTIPLES AUX PERFORMANCES AMELIOREES PAR UN CHAMP MAGNETIQUE ET PROCEDE ASSOCIE

(84) Designated Contracting States:
**AT BE CH DE ES FR GB GR IE IT LI NL SE**

(30) Priority: **13.05.1994 US 242581**

(43) Date of publication of application:
**17.07.1996 Bulletin 1996/29**

(73) Proprietor: **Applied Materials, Inc.**
**Santa Clara, CA 95054 (US)**

(72) Inventors:
- **YIN, Gerald Zheyao**
  **Cupertino, CA 95014 (US)**
- **HANAWA, Hiroji**
  **Santa Clara, CA 95051 (US)**
- **SMYTH, Kenneth**
  **Sunnyvale, CA 94087 (US)**

(74) Representative: **Bayliss, Geoffrey Cyril et al**
**BOULT WADE TENNANT,**
**27 Furnival Street**
**London EC4A 1PQ (GB)**

(56) References cited:
**US-A- 5 225 024**
**US-A- 5 330 606**
**US-A- 5 332 880**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 721 514 B1

Printed by Jouve, 75001 PARIS (FR)

## Description

## BACKGROUND OF THE INVENTION

This invention relates generally to plasma generation techniques, particularly as used in a dry etching process in the fabrication of integrated semiconductor devices. In dry etching, process gases are supplied to a vacuum chamber and radio-frequency (rf) energy generates and sustains a plasma cloud within the chamber. Ions in the plasma cloud bombard a workpiece, usually in the form of a semiconductor wafer, which may be located in the chamber immediately adjacent to the plasma, or in a separate processing chamber into which ions from the plasma are drawn. The ions either etch the workpiece or assist the etching, and the etching process may be made selective by patterning a protective coating applied to the workpiece prior to etching.

Various plasma generation techniques have been used and proposed, and specific prior art configurations are discussed further below, with reference to the drawings. In general, however, there are three types of plasma generation approaches: capacitive, inductive, and microwave. In the more conventional capacitive plasma approach, the plasma is formed between a pair of parallel plate electrodes, to which radio-frequency (rf) energy is applied, to one or both plates. A variant of the parallel plate approach is the magnetically enhanced reactive ion etch (MERIE) plasma generation apparatus, in which a magnetic field enhances the formation of ions in the plasma. Both the parallel plate configuration and the MERIE configuration use a single rf power generator.

Inductive plasma generators use an inductive coil, either a planar coil, a cylindrical coil or any of various other types of coils to deliver rf power into the plasma chamber. A separate rf generator supplies energy to at least one plate electrode in the chamber, to control ion energy and direction. The inductive plasma may also employ a magnetic enhancement device, such as a Helicon source.

In magnetically enhanced microwave (MEMW) plasma generators, energy is supplied to the plasma chamber at microwave frequency, through a waveguide. As in the inductive plasma generator, a second power generator supplies rf energy through an electrode plate, to control the plasma. Magnetic enhancement is applied if a high density plasma is desired, because at microwave frequencies the oscillated electrons in the plasma do not have enough kinetic energy to generate a requisite population of ions for etching. In the presence of an appropriate magnetic field, usually applied through a cylindrical coil around the chamber, the electrons gyrate in resonance with the microwave frequency, a condition referred to as electron cyclotron resonance (ECR).

Each of the prior art approaches to plasma generation has its advantages and disadvantages. The more conventional parallel plate capacitive plasma approach has the advantage of being a simple, relatively inexpensive, and mature technology, providing good process control and good repeatability of results. For these reasons, most manufacturing technology today continues to use this approach. Its principal disadvantage is that it is limited to relatively high chamber pressures, typically 100 millitorr (13.3 Pa) and above for a reactive ion etch (RIE) reactor and 20 millitorr (2.67 Pa) or above for a MERIE reactor. Below 20 millitorr (2.67 Pa), the mean free path of electrons in the plasma is comparable to the distance between the electrodes, and the electrons are unable to generate a high enough plasma density. Another disadvantage is that there is no independent control of plasma energy.

Inductive and microwave plasma generators overcome the disadvantages of the parallel plate plasma, but have significant disadvantages of their own. The advantages are that the plasma has a high density and can be generated at low pressure. Moreover, plasma generation and energy control are effectively decoupled by virtue of the separate power sources that are used. However, inductive and microwave plasma generators are more complex and more expensive than parallel plate configurations. When the rf power is applied to the cathode, the plasma source power does not have a proper grounding path. This may cause plasma process drift and non-reproducibility.

Accordingly, there is still a need for an improved plasma generation technique, preferably one that has the advantages of both parallel plate plasma and the microwave or inductive plasma. The present invention satisfies this need.

JP-A-06 045095 discloses an apparatus having the features set out in the precharacterizing portion of claim 1. A method according to the precharacterizing portion of claim 26 is also disclosed.

Embodiments of the present invention reside in a magnetically enhanced multiple capacitive plasma generation apparatus, and a related method for its operation.

According to a first aspect of the present invention, there is provided an apparatus as set out in claim 1. The invention also extends to a method for generating a controllable plasma within a plasma processing chamber as set out in claim 26.

Basically, the apparatus of the invention is a combination of a magnetically enhanced high-frequency rf source, using multiple capacitive plates located at the chamber sidewall, a conventional parallel plate rf source for plasma biasing and control, and a surrounding magnetic coil to provide a magnetic field perpendicular to the rf fields between the multiple capacitive plates.

Briefly, and in general terms, the invention may reside in apparatus for use in a plasma chamber having means for introducing plasma process gas and evacuable to preselected operating pressures for processing a substrate at a substrate support face defined by a support within the chamber. The apparatus comprises means for generating a first radio-frequency (rf) electric field in the chamber, referred to as a transverse electric field and directed across the chamber and generally parallel to the substrate support face; means for generating a magnetic field in the chamber generally perpendicular to the first rf electric field; means for generating a second rf electric field generally perpendicular to the first rf electric field; and means for varying at least one of the electric and magnetic fields to control the energy and density of the resulting plasma.

In the disclosed embodiment, the first rf power source operates at a frequency of approximately 13.5 megahertz (MHz) or higher, and the second rf power source operates at a frequency of approximately 13.5 MHz or less. More specifically, the first rf power source operates at a frequency in the range of approximately 50 to 200 MHz, and the second rf power source operates at a frequency in the range of approximately 400 kHz to 13.5 MHz. With the first rf power source operating at a a frequency of approximately 200 Mhz, the means for generating a magnetic field needs to produce a field strength of less than approximately 100 gauss, for operation at or near an electron cyclotron resonance condition, i.e. a radio-frequency ECR condition.

Preferably, there are n side electrodes, where n is at least four, and the first rf power source includes means for generating n rf signals, delayed from one to the next by a phase angle of (360/n)°, for application to the respective side electrodes to produce a rotating electric field in the plasma chamber. The optimum number of side electrodes is probably four or six. More than six adds complexity and cost, but fewer than four side electrodes does not sufficiently enhance the uniformity of plasma generation.

One aspect of the invention may comprise the steps of applying a first radio-frequency (rf) power signal to a plurality of side electrodes, disposed about the chamber sidewall, to produce an electric field transverse to the chamber sidewall; generating a magnetic field in the chamber generally perpendicular to the transverse electric field; and applying a second rf power signal to a pair of spaced, opposed upper and lower electrodes to produce an electric field in the chamber generally perpendicular to the transverse electric field, whereby the second rf signal provides control of the plasma energy to effect a desired process on a workpiece placed adjacent to one of the upper and lower electrodes for processing. The method provides separate controls of plasma energy and formation, operates over a wide range of chamber pressures and provides good process control and process repeatability.

It will be appreciated from the foregoing that the present invention represents a significant advance in plasma generation techniques. In particular, the invention provides a uniform, high-density plasma in a chamber that can be operated over a relatively wide range of pressures, and also provides good process control and process repeatability. The invention also has independent controls for plasma generation and plasma energy, and is less expensive and less complex than microwave ECR sources. Other aspects and advantages of the invention will become apparent from the following more detailed description, taken in conjunction with the accompanying drawings.

## BRIEF DESCRIPTION OF THE DRAWINGS

FIGURES 1a, 1b and 1c are simplified schematic views of three variants of capacitive plasma generation apparatus of the prior art;

FIGS. 2a, 2b and 2c are simplified schematic views of three variants of magnetically enhanced capacitive parallel plate plasma generation apparatus of the prior art;

FIGS. 3a, 3b and 3c are simplified schematic views of three variants of inductive plasma generation apparatus of the prior art;

FIGS. 4a, 4b and 4c are simplified schematic views of three variants of magnetically enhanced microwave (MEMW) plasma generation apparatus of the prior art;

FIG. 5 a simplified schematic view of a magnetically enhanced multiple capacitive plasma generation apparatus in accordance with the invention;

FIG. 6 is a simplified three-dimensional and schematic view of apparatus similar to that shown in FIG. 5, but including three pairs of side electrodes and with a processing chamber downstream of a plasma generation chamber;

FIG. 7 is a three-dimensional view similar to FIG. 5, but with two pairs of side electrodes;

FIG. 8 is a schematic view of associated apparatus for generating radio-frequency (rf) power to be applied to the two pairs of side electrodes in the apparatus of FIG. 7;

FIG. 9 is a set of four waveforms of rf power signals generated in the apparatus of FIGS. 7 and 8;

FIGS. 10a-10d are diagrams depicting how the apparatus of FIGS. 7 and 8 generate a rotating electric field (E field) vector;

FIG. 11 is a block diagram of a quadrature rf power splitter for use in the apparatus of FIG. 8; and

FIG. 12 is a block diagram of an alternative arrangement for generating four rf power signals to be applied to two pairs of side electrodes.

## DESCRIPTION OF THE PREFERRED EMBODIMENTS

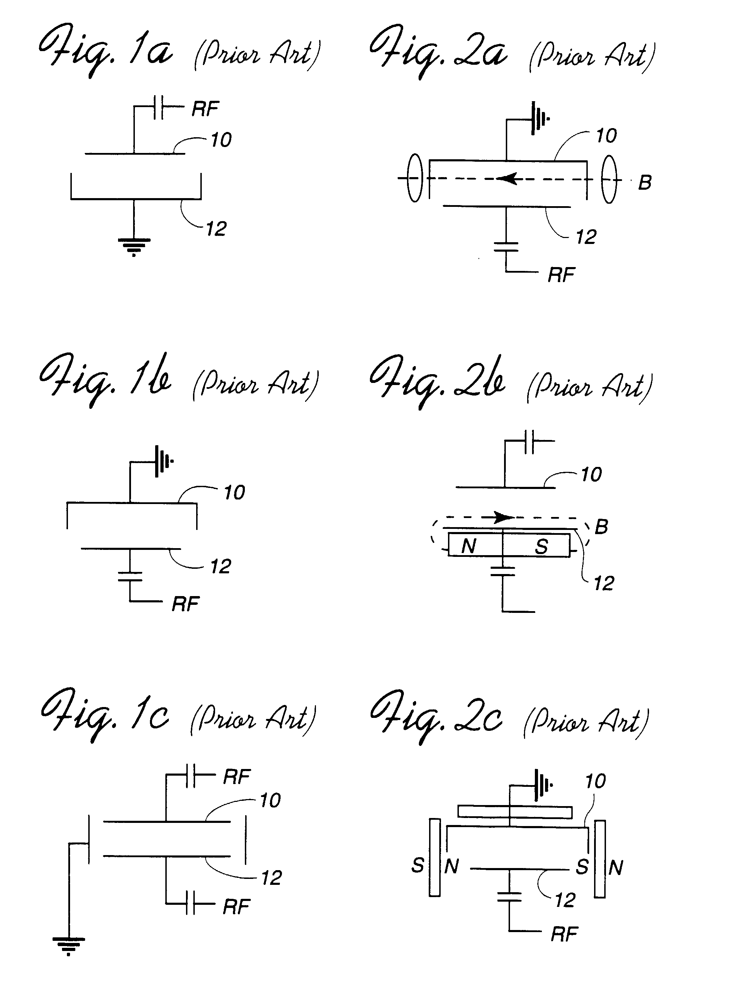

As shown in the drawings for purposes of illustration, the present invention is concerned with a novel technique for generating a plasma suitable for use in plasma processing of workpieces, as in reactive ion etching (RIE) of semiconductor wafers. One form of conventional plasma generation apparatus uses a pair of capacitive parallel plates, indicated at 10 and 12 in FIGS. 1a-1c. Radio-frequency (rf) power is applied to one or both plates through a series capacitor 14.

The parallel plate capacitive configuration is simple, relatively inexpensive to build, and provides relatively good process control and repeatability. Its principal drawback is that it is limited to operation only at relatively high pressures, typically above 100 millitorr (13.3 Pa). At lower pressures, the mean free path of electrons in the plasma region between the plates is comparable with the distance between the plates, and the plasma density is low. Another important disadvantage is that there is no separate control of the plasma energy. A workpiece (not shown) is typically positioned on the lower electrode 12, and ions in the plasma perform a processing function (etching) as they are drawn to the workpiece. The rf power applied to the plates affects both the generation of the plasma and its utilization as a processing tool. Ideally independent control of these functions is preferred.

FIGS. 2a-2c depict three variants of capacitive plate plasma generators with magnetic enhancement. That is to say, a magnetic field is applied to the plasma region between the parallel plates 10 and 12 or behind the plates, in a direction either perpendicular to the electric field between the plates or to the chamber walls. The figures depict three alternative approaches for generating the magnetic field, which enhances the formation of ions in the plasma. Electrons tend to gyrate about lines of magnetic flux, so the mean free path length of electrons is increased, and the likelihood of collisions between electrons and atoms is increased, which results in a higher rate of production of ions. These magnetically enhanced parallel plate configurations are known by the acronym MERIE, for magnetically enhanced reactive ion etching apparatus. Because plasma formation is enhanced, a MERIE device can operate at lower pressures, in the region of 10-200 millitorr (1.33 to 26.6 Pa) than the conventional parallel plate apparatus. However, as with parallel plate systems without magnetic enhancement, the MERIE device has only one rf power source, and therefore no effectively independent control of plasma density and energy, although the magnetic field can be considered as providing a weak independent control of plasma density.

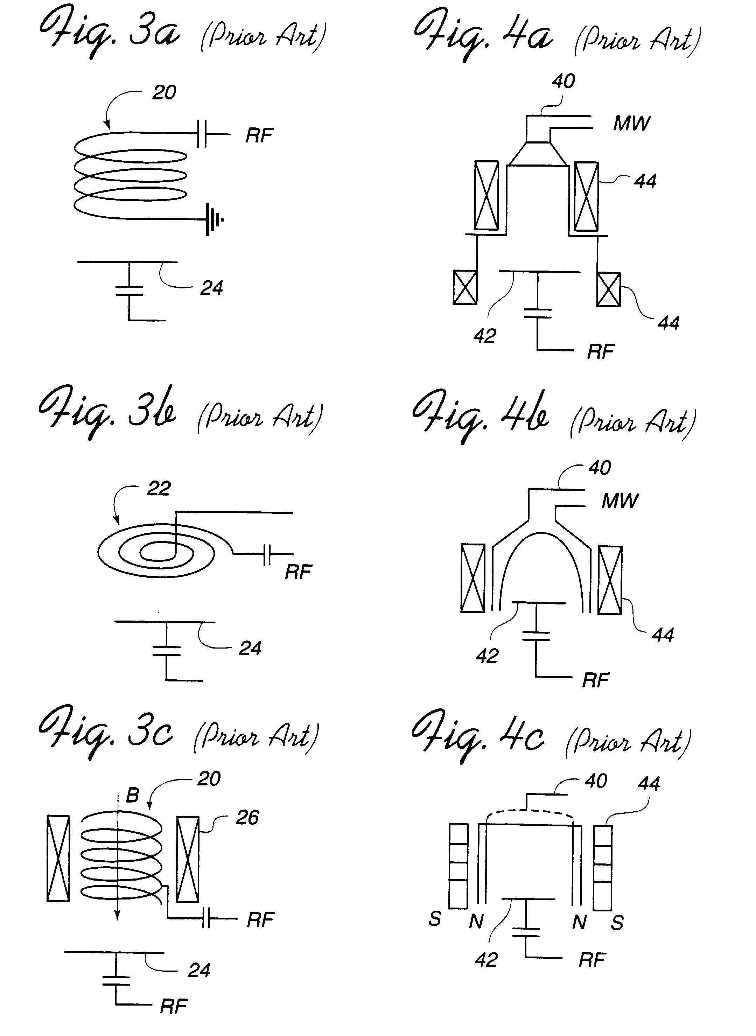

FIGS. 3a-3c depict another type of plasma generator of the prior art, using inductive coupling to inject rf power into a plasma chamber. In these configurations, two rf power sources are employed. One supplies the power to generate and sustain the plasma and is supplied through some type of inductive coil, either a cylindrical coil 20, as in FIGS. 3a and 3c, or a planar coil 22, as in FIG. 3b. A second source of rf power is connected to a lower electrode 24 and controls the plasma energy utilized in the etching or other process. The configuration of FIG. 3c also provides magnetic enhancement, as indicated by the magnetic field coil 26.

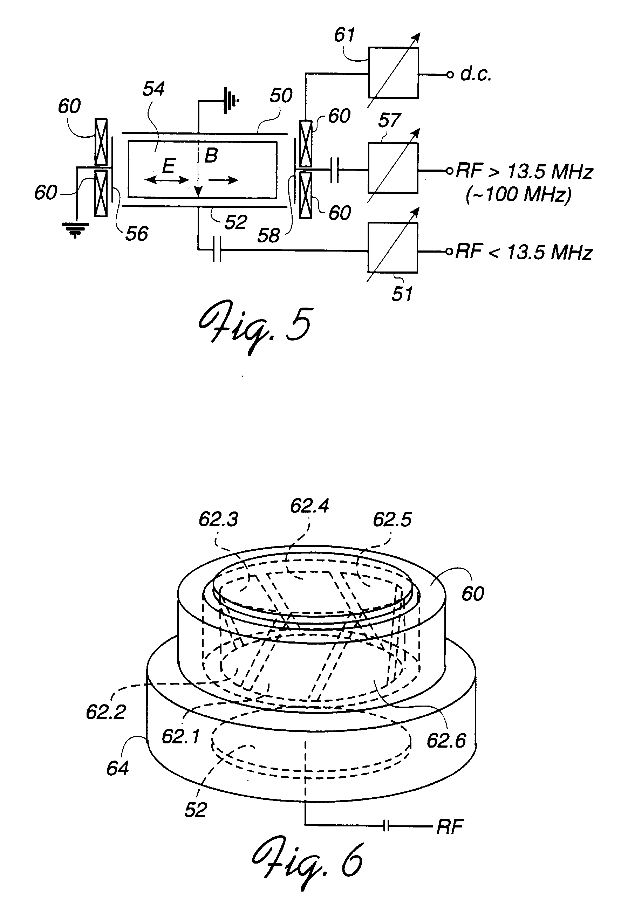

FIGS. 4a-4c depict yet another type of prior art apparatus for plasma generation, the magnetically enhanced microwave (MEMW) plasma generator. Rf power at microwave frequencies, which may be generally defined as falling within the range 300 MHz (megahertz) to 300 GHz (gigahertz), is coupled into a plasma chamber by some means, usually through the top of the chamber, as indicated at 40. A lower frequency rf power source is connected to a lower electrode 42, for plasma control, as in the inductive plasma generators. Magnetic enhancement is provided by field coils, as indicated at 44. These configurations are referred to by the acronym MEMW (magnetically enhanced microwave) plasma generators. If the strength of the magnetic field is appropriately selected, electrons in the plasma gyrate at a frequency in resonance with the microwave frequency, a condition referred to as electron cyclotron resonance (ECR). Alternatively, a slightly different magnetic field strength may be selected, for operation in an "off-resonance" condition.

Both inductive and MEMW plasma generators have the advantages of operating at high plasma density and low pressure, and providing separate plasma generation and energy controls. Their disadvantages are that they are complex and expensive, and provide limited process repeatability and control at low pressures.

The present invention has the advantages of both the parallel plate capacitive plasma generator and the inductive and MEMW configurations. The invention retains parallel plate electrodes for plasma energy control, and has magnetic enhancement using a relatively inexpensive magnetic field generator. For plasma generation, the invention uses a first rf generator connected to multiple side electrodes. The basic configuration is shown in FIG. 5. Parallel plate electrodes 50 and 52 are positioned above and below a plasma region 54. A semiconductor wafer (not shown) is held against either the lower electrode 52 or the upper electrode 50. In the configuration shown, the upper electrode 50 is grounded and rf power is applied to the lower electrode 52 to control the plasma. Alternatively, rf power may be applied to both electrodes 50 and 52, through an appropriate rf power splitter (not shown). The frequency of this rf source may be in the range 400 kHz - 13.5 MHz. Rf power to generate the plasma is supplied through side electrodes 56 and 58, one of which is shown as grounded and the other connected to a second rf power source, having a frequency above 13.5 MHz and preferably 50-200 MHz. The electric field generated between the side electrodes 56 and 58 is indicated by vector E. Magnetic field coils 60 are positioned around the plasma chamber, to provide a magnetic field, indicated by vector B, perpendicular to the E field.

The rf power supplied to the side electrodes 56 and 58 is controlled by a power controller 57. Similarly, the rf power applied to the upper and lower plates 50 and 52 is controlled by power controller 51. Control of rf power may be conveniently effected by varying the voltage of the rf signals. The strength of the magnetic field produced by the field coils 60 is controlled by a third controller 61, which varies the current supplied to the magnetic field coils.

A key advantage of the apparatus of the invention is that a relatively weak magnetic field is needed to achieve the electron cyclotron resonance (ECR) condition, as compared with the magnetic field needed in a magnetically enhanced microwave (MEMW) system. A similarly weak magnetic field is needed for the off-resonance condition. Simply stated, the reason for this difference in magnetic field strength is that a much stronger magnetic field is needed to cause electrons to gyrate at microwave frequencies than is needed at lower radio frequencies. As further explained below, use of the present invention, with its relatively weak magnetic field, produces higher collision energies than the microwave system. The following mathematical analysis highlights the advantages of the invention.

First, it is useful to compare the oscillation distance and energy of an electron subjected to an oscillating electric field between two electrodes. The oscillation distance $S_e$ and the electron energy $E_e$ are given by:

$$S_e = \frac{eV_0}{mD\omega^2}, \qquad E_e = \frac{e^2 V_0^2}{2mD^2\omega^2},$$

where:

e = electron charge,
m = electron mass,
$V_0$= voltage between the electrodes,
D = distance between the electrodes, and $\omega$ = angular frequency of rf power.

For D = 200 mm and $V_0$ = 2,000 volts, the following values of electron oscillation distance and energy may be calculated:

| Frequency | $S_e$ | $E_e$ |
|---|---|---|
| 400 kHz | 278 m | $1.39 \times 10^6$ ev |
| 13.56 MHz | 24 cm | $1.20 \times 10^3$ ev |
| 200 MHz | 0.11 cm | 5.55 ev |
| 2.45 GHz | $7.41 \times 10^{-3}$ mm | $3.70 \times 10^{-2}$ ev |

The electron gyration radius $r_g$ is given by the expression:

$$r_g = 2.38\,(T_e)^{1/2}\,B^{-1},$$

where:

$T_e$ = electron energy in electron-volts (ev), and
B = magnetic field strength (gauss).

Therefore, the electron gyration radius (in cm) may be calculated as follows for various values of B and $T_e$:

| Electron Energy (ev) | Magnetic Field Strength (gauss) | | | |
|---|---|---|---|---|
| | 100 | 200 | 300 | 875 |
| 10 | .075 cm | .038 cm | .025 cm | .0086 cm |
| 20 | .106 cm | .053 cm | .035 cm | .012 cm |

(continued)

| Electron Energy (ev) | Magnetic Field Strength (gauss) | | | |
|---|---|---|---|---|
| | 100 | 200 | 300 | 875 |
| 50 | .168 cm | .084 cm | .056 cm | .019 cm |
| 100 | .238 cm | .119 cm | .079 cm | .027 cm |

One significance of these data is that 875 gauss is the approximate magnetic field strength that is needed to achieve the ECR condition for a microwave plasma generator operating at a frequency of 2.45 GHz. This can be calculated from the expression for gyration frequency, which is:

$$f = \frac{eB}{2\pi m}.$$

The magnetic field strength needed to achieve ECR at a frequency of 200 MHz, however, is only 71.4 gauss. From the table above, the gyration radius values for the 100 gauss field strength are clearly larger than those obtained for 875 gauss, but are still less than a centimeter. More importantly, it is much less expensive to construct a magnetic field generator to produce the lower field strength of under 100 gauss, than to construct one with a field strength of 875 gauss, for use in apparatus operating at microwave frequencies.

It is also useful to compare electron collision energies and rates of a MEMW system in comparison with the magnetically enhanced multiple capacitive (MEMC) plasma generation apparatus of the present invention, both operating in the ECR condition. The mean free path of electrons in the plasma depends on the composition of the plasma and primarily on the pressure. For neutral argon gas, the mean free path lengths at various pressures are:

| | |
|---|---|
| 1 mtorr (133 mPa) | 48 mm |
| 10 mtorr (1.33 Pa) | 4.8 mm |
| 100 mtorr (13.3 Pa) | 0.48 mm |

The following table compares the two system, for various selected pressures and electron energies:

| System | MW ECR | | MEMC ECR | |
|---|---|---|---|---|
| Power | 1,500-3,000 w | | 50-1,000 w | |
| Frequency | 2.45 GHz | | 200 MHz | |
| e energy | 10 ev | | 10 ev | |
| $B_{ECR}$ | 875 gauss | | 71.4 gauss | |
| $r_g$ | 0.086 mm | | 1.05 mm | |
| Pressure | 1 mtorr | 10 mtorr | 1 mtorr | 10 mtorr |
| Circles/ collision | 88 | 8.8 | 7.2 | 0.72 |
| Collision Energy | 3.26 ev | 0.33 ev | 39 ev | 3.9 ev |
| Note that the collision energy is significantly higher in the system of the invention, for the same assumed pressure and electron energy. | | | | |

The present invention provides better independent control of the energy and density of the plasma. In prior systems with decoupled plasma energy and density controls, microwave or inductively coupled rf power was input to the chamber and was varied in power to control the plasma density, while the plasma energy was controlled by the power supplied to an rf bias electrode. In fact, the power applied to the plasma (the source power) and the power applied to the bias electrode (the bias power) both affect the plasma energy. As the source power is increased, more plasma gas particles are ionized, producing a higher plasma density. However, as the plasma density is increased there is an increase in current through the plasma sheath and a lower associated voltage drop. The dc bias associated with the plasma therefore drops and this is a measure of the energy of ions impinging on the substrate from the plasma. Increasing the bias power also increases the plasma energy. In theory, then, plasma density can be increased by simply increasing the rf plasma source power, without increasing the plasma energy at the same time. However, increasing the plasma source rf power produces high-energy ions, so that increasing the plasma density by increasing the plasma source rf power is accompanied by an unwanted increase in plasma energy.

In the present invention, plasma density is enhanced by increasing the strength of the magnetic field. The magnetic field causes electrons in the plasma to gyrate and produce more collisions, which increases the plasma density without increasing the energy. In fact dc bias, and with it the plasma energy, are reduced as a result of the increased plasma density. In brief, the invention provides three controls over plasma density and energy, and affords more independent control over these parameters.

In the embodiment of FIG. 6, there are three pairs of side electrodes, shown at 62.1 - 62.6. As will be discussed with respect to FIGS. 8 and 9, the side electrodes are connected in pairs of diametrically opposed electrodes, with each plate being supplied with an rf signal that is delayed in phase with respect to an adjacent electrode. For six electrodes, the phase delay between adjacent electrodes in the FIG. 6 embodiment is (360/6)° or 60°. Edges of adjacent electrodes are shown as being parallel with each other, but not parallel with the principal axis of the plasma chamber, to smooth any discontinuities that arise from having abrupt terminations in the electrode surfaces. FIG. 6 also depicts a configuration in which the plasma is utilized in a downstream processing chamber 64. Basically, in designing the specific structure of the processing system the lower electrode may be raised for *in situ* plasma processing, or lowered for downstream processing.

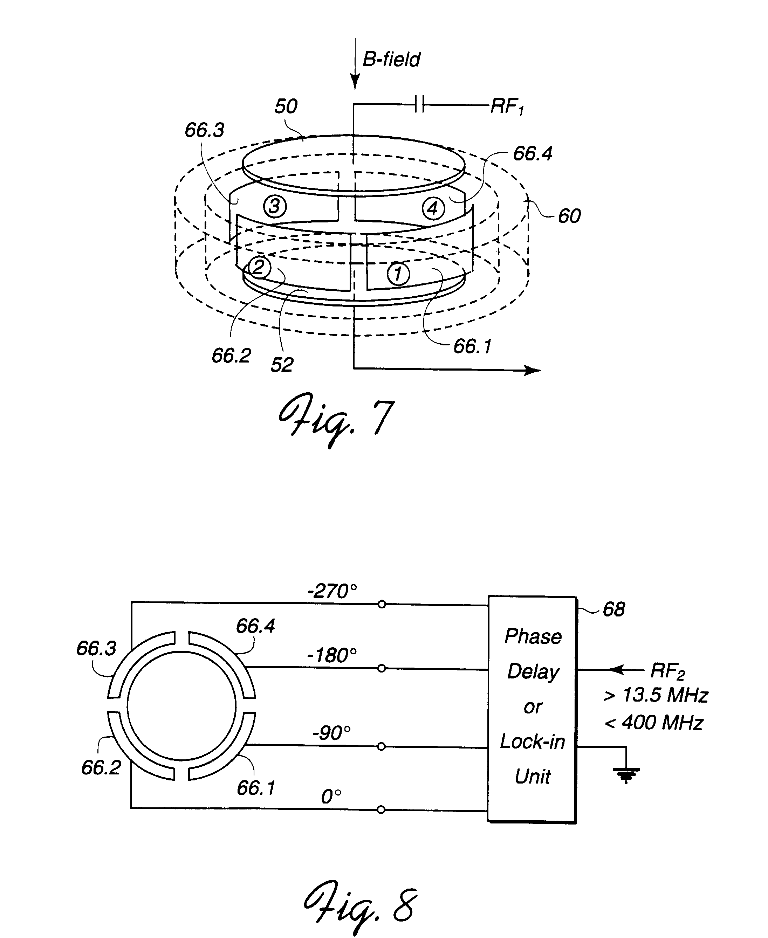

FIG. 7 shows an embodiment similar to that of FIG. 6, but in which there are four side electrodes 66.1 - 66.4, uniformly spaced about the plasma chamber. In this case, the rf signals applied to adjacent side electrodes are displaced in phase by 90°, as shown in FIG. 8. An rf signal is applied to a phase delay and splitting circuit 68, which generates four separate signals, on lines connected to the side electrodes 66.1 - 66.4, respectively.

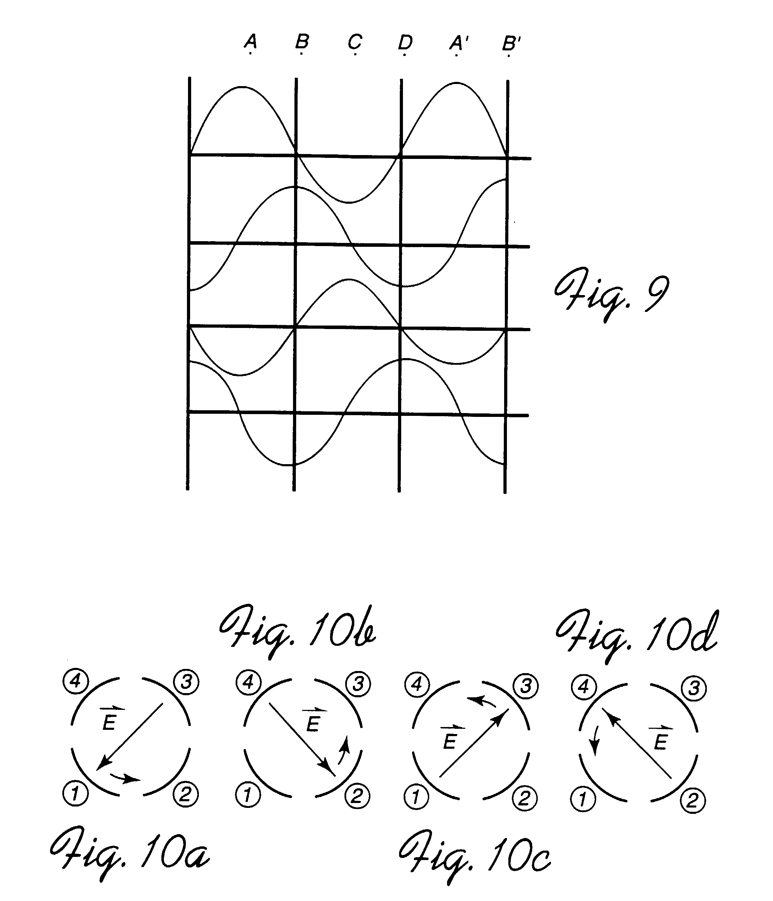

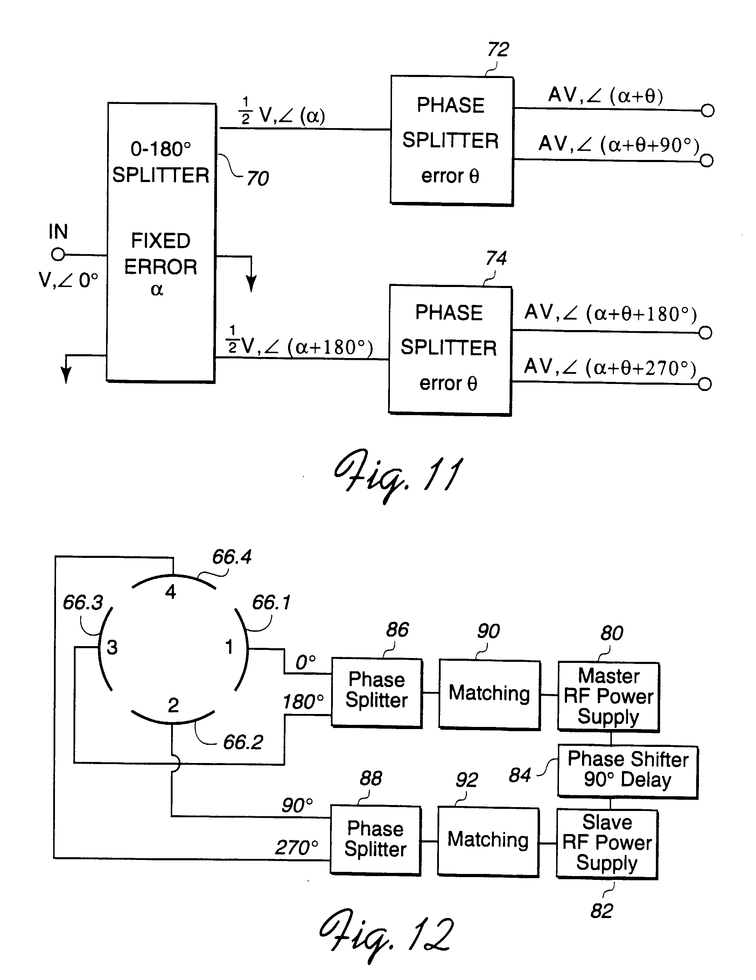

FIGS. 9 and 10a-10d show how the circuit of FIG. 8 produces a rotating electric field (shown by vector E). FIG. 9 shows the waveforms of the rf signals applied to the electrodes 66.1 - 66.4, respectively. These are alternating current (ac) signals displaced by 90° from one electrode to the next. FIG. 10a shows the direction of the peak E-field vector at a time corresponding to A in FIG. 9. The vector is directed from electrode 66.3 to electrode 66.1. Ninety degrees later in the cycle, at time B in FIG. 9, the peak E-field vector is directed from electrode 66.4 to electrode 66.2, as shown in FIG. 10b. After another ninety degrees, at time C in FIG. 9, the vector is directed from electrode 66.1 to electrode 66.3. And after a further ninety degrees, at time D in FIG. 9, the vector is directed from electrode 66.2 to electrode 66.4. It will be seen from FIGS. 11a-11d that effect of the rf signals applied to the four side electrodes is to produce a rotating electric field. This enhances uniformity of plasma formation.

FIG. 11 shows one way of implementing the rf phase delay and splitting circuit 68 of FIG. 8. The circuit includes a 0°-180° splitter 70 and two 0°-90° splitters 72 and 74. Since the splitters cannot, in general, be implemented without some level of angle error, the splitter 70 is assumed to introduce a fixed error a. Thus, if the input to splitter 70 is assumed to be a signal $V_1$ at angle 0°, the outputs will be $V_1/2$ at an angle a and $V_2/2$ at an angle $(\alpha + 180)°$. If the other splitters 72 and 74 are assumed to introduce a fixed error $\theta$, and an amplification factor A, the outputs of splitter 72 will be signals $AV_1$ at angles $(\alpha+\theta)$ and $(\alpha+\theta+90)°$, and the outputs of splitter 74 will be signals $AV_1$ at angles $(\alpha+\theta+180)°$ and $(\alpha+\theta+270)°$. Since the same errors appear in all four outputs they do not adversely affect operation of the invention. The 180° splitter 70 can be implemented as simple inductive element to provide the desired phase reversal. The 90° splitters 72 and 74 can be implemented with conventional rf inductive and capacitive components connected in T- or pi-sections.

FIG. 12 depicts an alternative approach for generating four rf power signals to be applied to the electrodes 66.1-66.4, respectively. This apparatus includes a master rf power supply 80, and a slave rf power supply 82 that is coupled to the master rf power supply through a 90° phase delay circuit 84. The apparatus further includes two 0°-180° splitters 86 and 88 and two conventional matching networks 90 and 92. Power signals from the rf power supplies 80 and 83 are connected through the matching networks 90 and 92 to respective 0°-180° splitters 86 and 88. Splitter 86 generates rf power signals at angles 0° and 180° for connection to electrodes 66.1 and 66.3, respectively, and splitter 88 generates rf power signals at angles 90° and 270° for connection to electrodes 66.2 and 66.4, respectively.

It will be appreciated from the foregoing that the present invention represents a significant advance in the field of plasma generation apparatus. In particular, the invention combines the advantages of conventional parallel plate plasma generation with those of inductive plasma generation. The resulting apparatus can be operated efficiently at either high or low pressures and provides separate plasma control and good process control and repeatability. Moreover, for operation at or near the electron cyclotron resonance (ECR) condition, a much weaker (and therefore less expensive) magnetic field is needed than for operation of a comparable microwave plasma apparatus at the ECR condition.

## Claims

1. Apparatus comprising:

a plasma chamber evacuable to preselected operating pressures and capable of maintaining a gaseous wafer processing environment, the plasma chamber including a substrate at a substrate support face defined by a support within the chamber, the apparatus further comprising:

first electrodes (56, 58) for supporting a first radio-frequency (rf) electric field directed across the substrate support face; and

second electrodes (50, 52) for supporting a second rf electric field transverse to the first rf electric field; characterised by:

at least one magnetic field support device (60) for supporting a magnetic field in the chamber transverse to the first rf electric field; and

a controller (51, 57, 61) to vary at least one of the electric and magnetic fields to control the energy and density of the resulting plasma.

**2.** Apparatus as defined in claim 1, and further including means (68) for rotating the first rf electric field.

**3.** Apparatus as defined in claim 1, wherein the controller (51, 57, 61) varies the magnetic field while maintaining the electric fields constant, to obtain a desired plasma density without significantly affecting the plasma energy.

**4.** Apparatus as defined in claim 3, wherein the controller (51, 57, 61) increases the strength of the magnetic field to obtain a desired high plasma density without increasing the plasma energy.

**5.** Apparatus as defined in claim 1, wherein said second electrodes (50, 52) include a pair which is positioned generally parallel to and on opposite sides of the substrate support face.

**6.** Apparatus as in claim 5, in which at least one electrode (52) of said pair of second electrodes (50, 52) is capacitively coupled to rf power.

**7.** Apparatus as defined in claim 6, wherein the other electrode (50) of the pair of second electrodes (50, 52) is grounded.

**8.** Apparatus as defined in claim 5, wherein said pair of second electrodes (50, 52) is rf powered, with one of said pair at a 180° phase delay relative to the other electrode of said pair.

**9.** Apparatus as defined in claim 1, wherein said first electrodes (56,58) include a pair of electrodes disposed in surrounding relationship to the chamber environment.

**10.** Apparatus as in claim 9, in which one electrode (58) of said pair of first electrodes (56, 58) is capacitively coupled to rf power.

**11.** Apparatus as defined in claim 9, wherein a plurality of said first electrode pairs (62.1...62.6; 66.1...66.4) are provided in symmetrical disposition, with each pair of electrodes being in opposing relationship.

**12.** Apparatus as defined in claim 11, wherein one of each of said first electrode additional pairs is rf powered, with 180° phase delay relative to the opposite electrode of the pair.

**13.** Apparatus as defined in claim 1, wherein said magnetic field support device (60) comprises a magnetic field coil positioned about the chamber.

**14.** Apparatus as defined in claim 1, wherein the magnetic field has a strength of about one hundred gauss (10mT) or less.

**15.** Apparatus as defined in claim 14, wherein the rf frequencies and magnetic field are related to each other for operation at or near an electron cyclotron resonance condition.

**16.** Apparatus as defined in claim 2, wherein the plasma is confined to a radially symmetrical region, and in which said first electrodes (56, 58) comprise a plurality of electrodes arranged radially symmetrically about the chamber wall.

**17.** Apparatus as defined in claim 1, in which said first electrodes (56, 58) direct the first rf electric field generally parallel to the wafer support face.

**18.** Apparatus as defined in claim 1, in which said magnetic field device (60) directs the magnetic field generally perpendicular to the first rf electric field.

**19.** Apparatus as in claim 1, in which said second electrodes (50, 52) direct the second rf electric field generally perpendicular to the first rf electric field.

**20.** Apparatus as defined in claim 1, wherein:

the first rf electric field operates at a frequency of approximately 13.5 megahertz (MHz) or higher; and
the second rf electric field operates at a frequency of approximately 13.5 MHz or lower.

**21.** Apparatus as defined in claim 20, wherein:

the first rf electric field operates at a frequency in the range of approximately 50 to 200 MHz; and
the second rf electric field operates at a frequency in the range of approximately 400 kHz to 13.5 MHz.

**22.** Apparatus as defined in claim 20, wherein:

the first rf electric field operates at a frequency of approximately 50-100 MHz; and
the magnetic field has a field strength of less than approximately 100 gauss (10mT), for operation at or near an electron cyclotron resonance condition.

**23.** Apparatus as defined in claim 1, wherein:

the first electrodes include n side electrodes, where n is at least four;
the apparatus includes a first rf power source (57) having means for generating n rf signals, delayed from one to the next by a phase angle of 360/n degrees, for application to the respective side electrodes to produce a rotating electric field in the plasma chamber.

**24.** Apparatus as defined in claim 23, wherein:

the number n of side electrodes (66.1...66.4) is four.

**25.** Apparatus as defined in claim 23, wherein:

the number n of side electrodes (62.1...62.6) is six.

**26.** A method for generating a controllable plasma within a plasma processing chamber adapted to be maintained at preselected operating pressures and into which may be introduced process gases for processing a substrate at a substrate support face defined by a support within the chamber, the method comprising the steps of:

generating a first radio-frequency (rf) electric field in the chamber across the substrate support face; and
generating a second rf electric field transverse to the first rf electric field; characterised by:
generating a magnetic field in the chamber transverse to the first rf electric field; and
varying at least one of the electric and magnetic fields to control the energy and density of the resulting plasma.

**27.** A method as defined in claim 26, and further including the step of rotating the first rf electric field.

**28.** A method as defined in claim 26, wherein the step of varying one of the electric and magnetic fields includes varying the magnetic field while maintaining the electric fields constant, to obtain a desired plasma density without significantly affecting the plasma energy.

**29.** A method as defined in claim 28, wherein the magnetic field is increased in strength to obtain a desired high plasma density without increasing the plasma energy.

**30.** A method as defined in claim 26, wherein the second rf electric field is generated by capacitively coupling rf power to at least one electrode (52) of a second pair of electrodes (50, 52) positioned generally parallel to and on opposite sides of the substrate support face.

**31.** A method as defined in claim 30, wherein the other electrode (50) of the second pair of electrodes (50, 52) is grounded.

**32.** A method as defined in claim 30, wherein the other electrode of the second pair of electrodes (50, 52) is rf powered, with a phase delay of 180° relative to the opposite electrode of the pair.

**33.** A method as defined in claim 26, wherein the first rf electric field is generated by capacitively coupling rf power to at least one electrode (58) of at least one additional pair of electrodes (56, 58) disposed in surrounding relationship to the chamber environment.

**34.** A method as defined in claim 33, wherein a plurality of additional pairs (62.1...62.6; 66.1...66.4) of electrodes are provided in symmetrical disposition, with each pair of additional electrodes being in opposing relationship.

**35.** A method as defined in claim 34, wherein one of each pair of additional electrodes is rf powered, but with 180° phase delay relative to the opposite electrode of the pair.

**36.** A method as defined in claim 26, wherein the magnetic field is provided by at least one magnetic field coil (60) positioned about the chamber.

**37.** A method as defined in claim 26, wherein the magnetic field has a strength of about one hundred gauss (10mT) or less.

**38.** A method as defined in claim 37, wherein the rf frequencies and magnetic field are related to each other for operation at or near an electron cyclotron resonance condition.

**39.** A method as defined in claim 27, wherein the plasma is confined to a radially symmetrical region, and in which said first electric field is generated by a plurality of electrodes (66.1...66.4; 62.1...62.6) arranged radially symmetrically about the chamber wall.

**40.** A method as defined in claim 26, wherein:

the step of generating the first rf electric field produces a signal at a frequency approximately 13.5 megahertz (MHz) or higher; and
the step of generating the second rf electric field produces a signal at a frequency of approximately 13.5 MHz or lower.

**41.** A method as defined in claim 40, wherein:

the step of generating the first rf electric field produces a signal at a frequency in the range of approximately 50 to 200 MHz; and
the step of generating the second rf electric field produces a signal at a frequency in the range of approximately 400 kHz to 13.5 MHz.

**42.** A method as defined in claim 40, wherein:

the step of generating the first rf electric field produces a signal at a frequency of approximately 50-100 MHz; and
the step of generating a magnetic field produces a field strength of less than approximately 50-100 gauss (5-10mT), for operation at or near an electron cyclotron resonance condition.

**43.** A method as defined in claim 26, wherein:

the plasma chamber has n side electrodes, where n is at least four;
the step of generating the first rf electric field includes generating n rf signals, delayed from one to the next by a phase angle of 360/n degrees, for application to the respective side electrodes to produce a rotating electric field in the plasma chamber.

**44.** A method as defined in claim 43, wherein:

the number n of side electrodes (66.1...66.4) is four.

**45.** A method as defined in claim 43, wherein:

the number n of side electrodes (62.1...62.6) is six.

**Patentansprüche**

**1.** Vorrichtung mit

einer Plasmakammer, die auf vorgewählte Betriebsdrücke evakuiert werden kann und eine Gas-Waferverarbeitungsumgebung aufrechterhalten kann, wobei die Plasmakammer ein Substrat auf einer durch eine Halterung in der Kammer definierten Substrathaltefläche aufweist, wobei die Vorrichtung weiter die folgenden Elemente aufweist:
erste Elektroden (56, 58) zum Aufrechterhalten eines ersten elektrischen HF-Felds über einen Bereich, in dem die Substrathaltefläche liegt, und
zweite Elektroden (50, 52) zum Aufrechterhalten eines zweiten elektrischen HF-Felds im rechten Winkel zum ersten elektrischen HF-Feld, gekennzeichnet durch:
mindestens eine Magnetfeld-Aufrechterhaltungsvorrichtung (60) zum Aufrechterhalten eines Magnetfelds in der Kammer im rechten Winkel zum ersten elektrischen HF-Feld, und
eine Steuerung (51, 57, 61) zum Verändern mindestens eines elektrischen Felds oder des Magnetfelds zum Steuern der Energie und Dichte des resultierenden Plasmas.

**2.** Vorrichtung nach Anspruch 1, weiter mit einer Einrichtung (68) zum Rotieren des ersten elektrischen HF-Felds.

**3.** Vorrichtung nach Anspruch 1, bei der die Steuerung (51, 57, 61) zum Erhalten einer erwünschten Plasmadichte ohne merkliche Beeinträchtigung der Plasmaenergie das Magnetfeld verändert, während die elektrischen Felder konstant gehalten werden.

**4.** Vorrichtung nach Anspruch 3, bei der die Steuerung (51, 57, 61) die Stärke des Magnetfelds erhöht, um ohne ein Erhöhen der Plasmaenergie eine erwünschte hohe Plasmadichte zu erhalten.

**5.** Vorrichtung nach Anspruch 1, bei der die zweiten Elektroden (50, 52) ein Paar aufweisen, das allgemein parallel zur Substratoberfläche und auf gegenüberliegenden Seiten der Substrathaltefläche angeordnet ist.

**6.** Vorrichtung nach Anspruch 5, bei der mindestens eine Elektrode (52) des Paars zweiter Elektroden (50, 52) kapazitiv an die HF-Energie gekoppelt ist.

**7.** Vorrichtung nach Anspruch 6, bei der die andere Elektrode (50) des Paars zweiter Elektroden (50, 52) geerdet ist.

**8.** Vorrichtung nach Anspruch 5, bei dem das Paar zweiter Elektroden (50, 52) mit HF-Energie versorgt wird, wobei eine Elektrode des Paars im Verhältnis zur anderen Elektrode des Paars um 180° phasenverschoben ist.

**9.** Vorrichtung nach Anspruch 1, bei der die ersten Elektroden (56, 58) ein Paar Elektroden aufweisen, die im Verhältnis zur Kammerumgebung in einer umgebenden Position angeordnet sind.

**10.** Vorrichtung nach Anspruch 9, bei der eine Elektrode (58) des Paars erster Elektroden (56, 58) kapazitiv an die HF-Energie gekoppelt ist.

**11.** Vorrichtung nach Anspruch 9, bei der mehrere erste Elektrodenpaare (62.1 ... 62.6; 66.1 ... 66.4) in symmetrischer Anordnung vorgesehen sind, wobei die Paare sich jeweils gegenüberliegen.

**12.** Vorrichtung nach Anspruch 11, bei der jedes der zusätzlichen ersten Elektrodenpaare mit HF-Energie versorgt wird, mit einer Phasenverzögerung um 180° im Verhältnis zur gegenüberliegenden Elektrode des Paars.

**13.** Vorrichtung nach Anspruch 1, bei dem die Magnetfeld-Aufrechterhaltungsvorrichtung (60) eine über der Kammer angeordnete Magnetfeldspule aufweist.

**14.** Vorrichtung nach Anspruch 1, bei der das Magnetfeld eine Stärke von ungefähr hundert Gauss (10mT) oder weniger hat.

**15.** Vorrichtung nach Anspruch 14, bei dem die HF-Frequenzen und das Magnetfeld so zueinander im Verhältnis stehen, daß ein Betrieb bei oder in der Nähe einer Elektron-Zyklotron-Resonanz-Bedingung entsteht.

**16.** Vorrichtung nach Anspruch 2, bei der das Plasma auf einen radialsymmetrischen Bereich beschränkt ist und bei der die ersten Elektroden (56, 58) mehrere Elektroden aufweisen, die radialsymmetrisch um die Kammerwand herum angeordnet sind.

**17.** Vorrichtung nach Anspruch 1, bei der die ersten Elektroden (56, 58) das erste elektrische HF-Feld allgemein parallel zur Waferhaltefläche ausrichten.

**18.** Vorrichtung nach Anspruch 1, bei dem die Magnetfeldvorrichtung (60) das Magnetfeld allgemein im rechten Winkel zum ersten elektrischen HF-Feld ausrichtet.

**19.** Vorrichtung nach Anspruch 1, bei der die zweiten Elektroden (50, 52) das zweite elektrische HF-Feld allgemein im rechten Winkel zum ersten elektrischen HF-Feld ausrichten.

**20.** Vorrichtung nach Anspruch 1, bei der:

das erste elektrische HF-Feld mit einer Frequenz von ungefähr 13,5 MHz oder höher betrieben wird und
das zweite elektrische HF-Feld mit einer Frequenz von ungefähr 13,5 MHz oder niedriger betrieben wird.

**21.** Vorrichtung nach Anspruch 20, bei der:

das erste elektrische HF-Feld mit einer Frequenz im Bereich von ungefähr 50 bis 200 MHz betrieben wird und
das zweite elektrische HF-Feld mit einer Frequenz im Bereich von ungefähr 400 kHz bis 13,5 MHz betrieben wird.

**22.** Vorrichtung nach Anspruch 20, bei der:

das erste elektrische HF-Feld mit einer Frequenz von ungefähr 50-100 MHz betrieben wird und
das Magnetfeld eine Feldstärke von weniger als ungefähr 100 Gauss (10mT) zum Betrieb bei oder in der Nähe einer Elektron-Zyklotron-Resonanz-Bedingung hat.

**23.** Vorrichtung nach Anspruch 1, bei der:

die ersten Elektroden n Seitenelektroden aufweisen, wobei n mindestens vier ist,
die Vorrichtung eine erste HF-Energiequelle (57) mit einer Einrichtung zum Erzeugen von n HF-Signalen aufweist, die von einem zum nächsten durch einen Phasenwinkel von 360/n Grad verzögert sind, die zum Erzeugen eines sich drehenden elektrischen Felds in der Plasmakammer an die entsprechenden Seitenelektroden angelegt werden.

**24.** Vorrichtung nach Anspruch 23, bei der:

die Anzahl n der Seitenelektroden (66.1 ... 66.4) vier ist.

**25.** Vorrichtung nach Anspruch 23, bei der:

die Anzahl n der Seitenelektroden (62.1 ... 62.6) sechs ist.

**26.** Verfahren zum Erzeugen eines steuerbaren Plasmas in einer Plasmaverarbeitungskammer, das bei vorgewählten Betriebsdrükken aufrechterhalten werden kann und in die Prozeßgase zum Verarbeiten eines Substrats an einer durch eine Halterung in der Kammer definierte Substrathaltefläche eingeleitet werden können, wobei das Verfahren die folgenden Schritte aufweist:

Erzeugen eines ersten elektrischen HF-Felds in der Kammer über einen Bereich, in dem die Substrathaltefläche liegt, und
Erzeugen eines zweiten elektrischen HF-Felds im rechten Winkel zum ersten elektrischen HF-Feld, gekennzeichnet durch:
Erzeugen eines Magnetfelds in der Kammer im rechten Winkel zum ersten elektrichen HF-Feld und
Verändern mindestens eines elektrischen Felds oder des Magnetfelds zum Steuern der Energie und Dichte des resultierenden Plasmas.

**27.** Verfahren nach Anspruch 26, weiter mit dem Schritt des Rotierens des ersten elektrischen HF-Felds.

**28.** Verfahren nach Anspruch 26, bei dem der Schritt des Veränderns eines elektrischen Felds oder des Magnetfelds aufweist, daß das Magnetfeld verändert wird, während die elektrischen Felder konstant gehalten werden, um so ohne merkliche Beeinträchtigung der Plasmaenergie eine erwünschte Plasmadichte zu erhalten.

**29.** Verfahren nach Anspruch 28, bei dem das Magnetfeld verstärkt wird, um eine erwünschte hohe Plasmadichte zu erhalten, ohne die Plasmaenergie zu erhöhen.

**30.** Verfahren nach Anspruch 26, bei dem das zweite elektrische HF-Feld durch ein kapazitives Koppeln von HF-Energie an mindestens eine Elektrode (52) eines zweiten Paars Elektroden (50, 52) erzeugt wird, die allgemein parallel und auf gegenüberliegenden Seiten der Substrathaltefläche angeordnet sind.

**31.** Verfahren nach Anspruch 30, bei dem die andere Elektrode (50) des zweiten Paars Elektroden (50, 52) geerdet ist.

**32.** Verfahren nach Anspruch 30, bei dem die andere Elektrode das zweiten Paars Elektroden (50, 52) mit einer Phasenverzögerung um 180° im Verhältnis zur gegenüberliegenden Elektrode des Paars mit HF-Energie versorgt wird.

**33.** Verfahren nach Anspruch 26, bei dem das erste elektrische HF-Feld durch kapazitives Koppeln von HF-Energie an mindestens eine Elektrode (58) mindestens eines zusätzlichen Elektrodenpaars (56, 58) erzeugt wird, die im Verhältnis zur Kammerumgebung in einer umgebenden Position angeordnet sind.

**34.** Verfahren nach Anspruch 33, bei dem mehrere zusätzliche Paare (62.1 ... 62.6; 66.1 ... 66.4) Elektroden in symmetrischer Anordnung vorgesehen sind, wobei jedes Paar zusätzlicher Elektroden sich gegenüberliegt.

**35.** Verfahren nach Anspruch 34, bei dem eine Elektrode jeden Paares zusätzlicher Elektroden mit HF-Energie versorgt wird, jedoch mit einer Phasenverzögerung von 180° im Verhältnis zur gegenüberliegenden Elektrode des Paars.

**36.** Verfahren nach Anspruch 26, bei dem das Magnetfeld durch mindestens eine Magnetfeldspule (60), die um die Kammer herum angeordnet ist, erzeugt wird.

**37.** Verfahren nach Anspruch 26, bei dem das Magnetfeld eine Stärke von ungefähr hundert Gauss (10mT) oder weniger hat.

**38.** Verfahren nach Anspruch 37, bei dem die HF-Frequenzen und das Magnetfeld so zueinander im Verhältnis stehen, daß ein Betrieb bei oder in der Nähe einer Elektron-Zyklotron-Resonanz-Bedingung entsteht.

**39.** Verfahren nach Anspruch 27, bei dem das Plasma auf einen radialsymmetrischen Bereich beschränkt ist und bei dem das erste elektrische Feld durch mehrere Elektroden (66.1 ... 66.4; 62.1 ... 62.6) erzeugt wird, die radialsymmetrisch um die Kammerwand herum angeordnet sind.

**40.** Verfahren nach Anspruch 26, bei dem:

der Schritt des Erzeugens des ersten elektrischen HF-Felds ein Signal mit einer Frequenz von ungefähr 13,5 MHz oder höher erzeugt und
der Schritt des Erzeugens des zweiten elektrischen HF-Felds ein Signal mit einer Frequenz von ungefähr 13,5 MHz oder weniger erzeugt.

**41.** Verfahren nach Anspruch 40, bei dem:

der Schritt des Erzeugens des ersten elektrischen HF-Felds ein Signal mit einer Frequenz im Bereich von ungefähr 50 bis 200 MHz erzeugt und
der Schritt des Erzeugens des zweiten elektrischen HF-Felds ein Signal mit einer Frequenz von im Bereich von ungefähr 400 kHz bis 13,5 MHz erzeugt.

**42.** Verfahren nach Anspruch 40, bei dem:

der Schritt des Erzeugens des ersten elektrischen HF-Felds ein Signal mit einer Frequenz im Bereich von ungefähr 50 bis 100 MHz erzeugt und
der Schritt des Erzeugens des Magnetfelds eine Feldstärke erzeugt, die zum Betrieb bei oder in der Nähe einer Elektron-Zyklotron-Resonanz-Bedingung geringer als ungefähr 50-100 Gauss (5-10mT) ist.

**43.** Verfahren nach Anspruch 26, bei dem:

die Plasmakammer n Seitenelektroden aufweist, wobei n mindestens vier ist,
der Schritt des Erzeugens eines ersten elektrischen HF-Felds das Erzeugen von n HF-Signalen aufweist, die von einem zum nächsten durch einen Phasenwinkel von 360/n Grad verzögert sind, die zum Erzeugen eines sich drehenden elektrischen Felds in der Plasmakammer an die entsprechenden Seitenelektroden angelegt werden.

**44.** Verfahren nach Anspruch 43, bei dem:

die Anzahl n der Seitenelektroden (66.1 ... 66.4) vier ist.

**45.** Verfahren nach Anspruch 43, bei dem:

die Anzahl n der Seitenelektroden (62.1 ... 62.6) sechs ist.

**Revendications**

**1.** Dispositif comprenant :

une chambre à plasma pouvant être évacuée à des pressions opérationnelles présélectionnées et susceptible de maintenir un environnement de traitement de plaquettes gazeux, la chambre à plasma comprenant un substrat au niveau d'une face de support de substrat définie par un support à l'intérieur de la chambre, le dispositif comprenant de plus :
des premières électrodes (56, 58) pour supporter un premier champ électrique de haute fréquence (HF) dirigé sur la face de support de substrat ; et
des deuxièmes électrodes (50, 52) pour supporter un deuxième champ électrique HF transversal au premier champ électrique HF ; caractérisé par :
au moins un dispositif de support de champ magnétique (60) pour supporter un champ magnétique dans la chambre transversalement au premier champ électrique HF ; et
un dispositif de commande (51, 57, 61) pour faire varier au moins l'un des champs électriques et magnétique afin de commander l'énergie et la densité du plasma résultant.

**2.** Dispositif selon la revendication 1, et comprenant de plus des moyens (68) pour faire tourner le premier champ électrique HF.

**3.** Dispositif selon la revendication 1, dans lequel le dispositif de commande (51, 57, 61) fait varier le champ magnétique tout en maintenant constants les champs électriques, de façon à obtenir une densité de plasma désirée sans affecter de façon significative l'énergie de plasma.

**4.** Dispositif selon la revendication 3, dans lequel le dispositif de commande (51, 57, 61) augmente la force du champ magnétique de façon à obtenir une densité de plasma élevée désirée sans augmenter l'énergie de plasma.

**5.** Dispositif selon la revendication 1, dans lequel lesdites deuxièmes électrodes (50, 52) comprennent une paire qui est positionnée globalement parallèlement à la face de support de substrat et sur des côtés opposés de celle-ci.

**6.** Dispositif selon la revendication 5, dans lequel au moins une électrode (52) de ladite paire de deuxièmes électrodes (50, 52) est couplée de façon capacitive à l'alimentation HF.

**7.** Dispositif selon la revendication 6, dans lequel l'autre électrode (50) de la paire de deuxièmes électrodes (50, 52) est mise à la masse.

**8.** Dispositif selon la revendication 5, dans lequel ladite paire de deuxièmes électrodes (50, 52) est alimentée en haute fréquence, avec l'une de ladite paire à un retard de phase de 180° par rapport à l'autre électrode de ladite paire.

**9.** Dispositif selon la revendication 1, dans lequel lesdites premières électrodes (56, 58) comprennent une paire d'électrodes disposées en relation d'entourage par rapport à l'environnement de la chambre.

**10.** Dispositif selon la revendication 9, dans lequel une électrode (58) de ladite paire de premières électrodes (56, 58) est couplée de façon capacitive à l'alimentation HF.

**11.** Dispositif selon la revendication 9, dans lequel une pluralité desdites premières paires d'électrodes (62.1, ..., 62.6 ; 66.1, ..., 66.4) sont disposées selon une disposition symétrique, chaque paire d'électrodes étant en relation opposée.

**12.** Dispositif selon la revendication 11, dans lequel l'une de chacune desdites premières paires additionnelles d'électrodes est alimentée en haute fréquence, avec un retard de phase de 180° par rapport à l'électrode opposée de la paire.

**13.** Dispositif selon la revendication 1, dans lequel ledit dispositif de support de champ magnétique (60) comprend un enroulement de champ magnétique positionné autour de la chambre.

**14.** Dispositif selon la revendication 1, dans lequel le champ magnétique a une force d'environ cent gauss (10 mT) ou moins.

**15.** Dispositif selon la revendication 14, dans lequel les fréquences HF et le champ magnétique sont liés les uns aux autres pour le fonctionnement dans une condition de résonance de cyclotron à électrons ou au voisinage de celle-ci.

**16.** Dispositif selon la revendication 2, dans lequel le plasma est confiné dans une région radialement symétrique, et dans lequel lesdites premières électrodes (56, 58) comprennent une pluralité d'électrodes disposées radialement de façon symétrique autour de la paroi de la chambre.

**17.** Dispositif selon la revendication 1, dans lequel lesdites premières électrodes (56, 58) dirigent le premier champ électrique HF globalement parallèlement à la face de support de plaquette.

**18.** Dispositif selon la revendication 1, dans lequel ledit dispositif de champ magnétique (60) dirige le champ magnétique globalement perpendiculairement au premier champ électrique HF.

**19.** Dispositif selon la revendication 1, dans lequel lesdites deuxièmes électrodes (50, 52) dirigent le champ électrique HF second globalement perpendiculairement au premier champ électrique HF.

**20.** Dispositif selon la revendication 1, dans lequel :

le premier champ électrique HF fonctionne à une fréquence d'approximativement 13,5 mégahertz (MHz) ou plus ; et
le deuxième champ électrique HF agit à une fréquence d'approximativement 13,5 MHz ou moins.

**21.** Dispositif selon la revendication 20, dans lequel :

le premier champ électrique HF agit à une fréquence dans la plage d'approximativement 50 à 200 MHz ; et
le deuxième champ électrique HF agit à une fréquence dans la plage d'approximativement 400 kHz à 13,5 MHz.

**22.** Dispositif selon la revendication 20, dans lequel :

le premier champ électrique HF agit à une fréquence d'approximativement 50 à 100 MHz ; et
le champ magnétique a une force de champ inférieure à approximativement cent gauss (10 mT), pour le fonctionnement dans une condition de résonance de cyclotron à électrons ou au voisinage de celle-ci.

**23.** Dispositif selon la revendication 1, dans lequel :

les premières électrodes comprennent n électrodes latérales, n étant au moins égal à quatre ;
le dispositif comprend une première source d'alimentation HF (57) comportant des moyens pour générer n signaux HF, retardés de l'un à l'autre d'un angle de phase de 360/n degrés, pour l'application aux électrodes latérales respectives afin de produire un champ électrique tournant dans la chambre à plasma.

**24.** Dispositif selon la revendication 23, dans lequel :

le nombre n d'électrodes latérales (66.1, ..., 66.4) est de quatre.

**25.** Dispositif selon la revendication 23, dans lequel :

le nombre n d'électrodes latérales (62.1, ..., 62.6) est de six.

**26.** Procédé pour générer un plasma pouvant être contrôlé à l'intérieur d'une chambre de traitement de plasma adaptée pour être maintenue à des pressions de fonctionnement présélectionnées, et dans laquelle peuvent être introduits des gaz de traitement pour traiter un substrat au niveau d'une face de support de substrat définie par un support à l'intérieur de la chambre, le procédé comprenant les étapes suivantes :

la génération d'un premier champ électrique haute fréquence (HF) dans la chambre sur la face de support de substrat ; et
la génération d'un deuxième champ électrique HF transversal au premier champ électrique HF ;

caractérisé par :

la génération d'un champ magnétique dans la chambre transversalement au premier champ électrique HF ; et
le fait de faire varier au moins l'un des champs électriques et magnétique pour contrôler l'énergie et la densité du plasma résultant.

**27.** Procédé selon la revendication 26, et comprenant de plus l'étape consistant à faire tourner le premier champ électrique HF.

**28.** Procédé selon la revendication 26, dans lequel l'étape consistant à faire varier l'un des champs électriques et magnétique comprend le fait de faire varier le champ magnétique tout en maintenant constants les champs électriques, de façon à obtenir une densité de plasma désirée sans affecter de façon significative l'énergie de plasma.

**29.** Procédé selon la revendication 28, dans lequel on augmente la force du champ magnétique afin d'obtenir une densité de plasma élevée désirée sans augmenter l'énergie de plasma.

**30.** Procédé selon la revendication 26, dans lequel le deuxième champ électrique HF est généré en couplant de façon capacitive une alimentation HF à au moins une électrode (52) d'une seconde paire d'électrodes (50, 52) positionnée globalement parallèlement à la face de support de substrat et sur des côtés opposés de celle-ci.

**31.** Procédé selon la revendication 30, dans lequel l'autre électrode (50) de la seconde paire d'électrodes (50, 52) est mise à la masse.

**32.** Procédé selon la revendication 30, dans lequel l'autre électrode de la seconde paire d'électrodes (50, 52) est alimentée en haute fréquence, avec un retard de phase de 180° par rapport à l'électrode opposée de la paire.

**33.** Procédé selon la revendication 26, dans lequel le premier champ électrique HF est généré en couplant de façon capacitive une alimentation HF à au moins une électrode (58) d'au moins une paire additionnelle d'électrodes (56, 58) disposée en relation d'entourage par rapport à l'environnement de la chambre.

**34.** Procédé selon la revendication 33, dans lequel une pluralité de paires additionnelles (62.1, ..., 62.6 ; 66.1, ..., 66.4) d'électrodes sont disposées dans une disposition symétrique, chaque paire d'électrodes additionnelles étant en relation opposée.

**35.** Procédé selon la revendication 34, dans lequel l'une de chaque paire d'électrodes additionnelles est alimentée en haute fréquence, mais avec un retard de phase de 180° par rapport à l'électrode opposée de la paire.

**36.** Procédé selon la revendication 26, dans lequel le champ magnétique est délivré par au moins une bobine de champ magnétique (60) disposée autour de la chambre.

**37.** Procédé selon la revendication 26, dans lequel le champ magnétique a une force d'environ cent gauss (10 mT) ou moins.

**38.** Procédé selon la revendication 37, dans lequel les fréquences HF et le champ magnétique sont liés les uns aux autres pour le fonctionnement dans une condition de résonance de cyclotron à électrons ou au voisinage de celle-ci.

**39.** Procédé selon la revendication 27, dans lequel le plasma est confiné à une région radialement symétrique, et dans lequel le premier champ électrique est généré par une pluralité d'électrodes (66.1, ..., 66.4 ; 62.1, ..., 62.6) disposées radialement symétriquement autour de la paroi de la chambre.

**40.** Procédé selon la revendication 26, dans lequel :

l'étape de génération du premier champ électrique HF produit un signal à une fréquence approximativement supérieure ou égale à 13,5 mégahertz (MHz) ; et
l'étape de génération du deuxième champ électrique HF produit un signal à une fréquence approximativement inférieure ou égale à 13,5 MHz.

**41.** Procédé selon la revendication 40, dans lequel :

l'étape de génération du premier champ électrique HF produit un signal à une fréquence dans la plage d'approximativement 50 à 200 MHz ; et
l'étape de génération du deuxième champ électrique HF produit un signal à une fréquence dans la plage d'approximativement 400 kHz à 13,5 MHz.

**42.** Procédé selon la revendication 40, dans lequel :

l'étape de génération du premier champ électrique HF produit un signal à une fréquence d'approximativement 50 à 100 MHz ; et
l'étape de génération d'un champ magnétique produit une force de champ inférieure à environ 50 à 100 gauss (5 à 10 mT), pour le fonctionnement dans une condition de résonance de cyclotron à électrons ou au voisinage de celle-ci.

**43.** Procédé selon la revendication 26, dans lequel :

la chambre à plasma comporte n électrodes latérales, n étant au moins égal à quatre ;
l'étape de génération du premier champ électrique HF comprend la génération de n signaux HF, retardés de l'un à l'autre d'un angle de phase de 360/n degrés, pour l'application aux électrodes latérales respectives afin de produire un champ électrique tournant dans la chambre à plasma.

**44.** Procédé selon la revendication 43, dans lequel :

le nombre n d'électrodes latérales (66.1, ..., 66.4) est de quatre.

**45.** Procédé selon la revendication 43, dans lequel :

le nombre n d'électrodes latérales (62.1, ..., 62.6) est de six.

Fig. 1a (Prior Art)

RF
10
12

Fig. 2a (Prior Art)

10
B
12
RF

Fig. 1b (Prior Art)

10
12
RF

Fig. 2b (Prior Art)

10
B
N
S
12

Fig. 1c (Prior Art)

RF
10
12
RF

Fig. 2c (Prior Art)

10
S
N
S
N
12
RF

Fig. 3a (Prior Art)

20
RF
24

Fig. 3b (Prior Art)

22
RF
24

Fig. 3c (Prior Art)

20
B
26
RF
24
RF

Fig. 4a (Prior Art)

40
MW
44
44
42
RF

Fig. 4b (Prior Art)

40
MW
44
42
RF

Fig. 4c (Prior Art)

40
44
S
N
N
S
42
RF

61
d.c.
54
50
60
60
57
B
E
RF > 13.5 MHz
(~100 MHz)
60
60
52
58
56
RF < 13.5 MHz
51

Fig. 5

62.4
62.3
62.5
60
62.2
62.1
62.6
64
52
RF

Fig. 6

B-field
RF1
50
66.3
66.4
60
3
4
2
1
66.2
52
66.1

Fig. 7

-270°
68
66.4
66.3
-180°
Phase
Delay
or
Lock-in
Unit
RF2
> 13.5 MHz
< 400 MHz
-90°
66.2
66.1
0°

Fig. 8

A
B
C
D
A'
B'

Fig. 9

4
3
E
1
2
4
3
E
1
2
4
3
E
1
2
4
3
E
1
2

Fig. 10a

Fig. 10b

Fig. 10c

Fig. 10d

72
PHASE
SPLITTER
error θ
AV,∠ (α+θ)
AV,∠ (α+θ+90°)
½ V,∠ (α)
0-180°
SPLITTER
70
IN
V,∠ 0°
FIXED
ERROR
α
74
PHASE
SPLITTER
error θ
AV,∠ (α+θ+180°)
AV,∠ (α+θ+270°)
½V,∠ (α+180°)

Fig. 11

66.4
66.3
66.1
4
3
1
2
66.2
0°
180°
90°
270°
86
90
80
Phase
Splitter
Matching
Master
RF Power
Supply
84
Phase Shifter
90° Delay
88
92
Phase
Splitter
Matching
Slave
RF Power
Supply
82

Fig. 12